# EUROPÄISCHE PATENTSCHRIFT

(11) **EP 0 841 719 B1**
(45) Veröffentlichungstag und Bekanntmachung des Hinweises auf die Patenterteilung: **12.06.2002**
(21) Anmeldenummer: 97118129.2
(22) Anmeldetag: 18.10.1997
(51) Int. Cl.: H01R 12/32, H01R 43/20

(54) **Kontaktstift**
Contact pin
Broche de contact

(30) Priorität: 06.11.1996 DE 19645704
(43) Veröffentlichungstag der Anmeldung: 13.05.1998
(73) Patentinhaber: Weidmüller Interface GmbH & Co., D-32758 Detmold (DE)
(72) Erfinder: Kolb, Rudi, 87629 Füssen-Hopfen (DE)
(74) Vertreter: Hübner, Hans-Joachim, Dipl.-Ing.

(56) Entgegenhaltungen:
- EP-A- 0 522 613
- GB-A- 411 383
- GB-A- 2 195 836
- US-A- 3 634 819
- US-A- 4 753 602
- US-A- 4 867 710

## Beschreibung

Die Erfindung betrifft einen Kontaktstift zur lötfreien Befestigung in metallisierten Leiterplattenbohrungen mit einem Schaft, einem elastisch verformbaren Einpressabschnitt und einer Stiftkuppe, wobei der Einpressabschnitt mindestens drei, sich im wesentlichen achsparallel über die Länge des Einpressabschnittes erstreckende Kontaktzonen aufweist, die auf einem Durchmesser größer als der Lochdurchmesser der Leiterplattenbohrungen liegen und mit einem, dem Einpressabschnitt in Einsteckrichtung vorgeschalteten Übergangsabschnitt, der ebenfalls Kontaktzonen aufweist, die sich an diejenigen des Einpressabschnittes anschließen und auf einer wenigstens angenähert konischen Übergangsfläche liegen und im Abstand von der Stiftkuppe enden.

Ein derartiger Kontaktstift ist aus der DE-3909310-A1 oder aus der US-A-3 634 819 bekannt. Im Einpressabschnitt und im Übergangsabschnitt ist eine Mulde eingeprägt, wodurch zwei Rippen entstehen, die durch eine dünne Brücke miteinander verbunden sind. An den Außenkanten der beiden Rippen werden Kontaktzonen gebildet, die beim Einpressen des Kontaktstiftes in die Leiterplattenbohrung elastisch an der Innenfläche der Bohrung angedrückt werden.

Einen ähnlichen Stand der Technik zeigt die DE-3804041-A1 bei der gesagt ist, daß der Übergangsabschnitt ein sanftes Eintauchen und Einpressen des Kontaktstiftes in die Leiterplattenbohrung bewirkt. An den Übergangsabschnitt schließt sich zur Stiftkuppe hin ein im allgemeinen quadratischer Endabschnitt an, dessen Querschnitt erheblich geringer ist als derjenige der Leiterplattenbohrung.

Die EP 0059462 und 0221092 sowie die US 3,837,063 zeigen einen ähnlichen Stand der Technik.

Um eine Leiterplatte mit solchen Kontaktstiften maschinell zu bestücken, muß jeder Stift in einem Handlingsgerät geklemmt und dann exakt positioniert werden, bevor der Einpressvorgang durchgeführt werden kann.

Aufgabe der Erfindung ist, den Kontaktstift der eingangs genannten Art so auszubilden, daß er sich in einer Leiterplatte vorzentrieren läßt, so daß eine Anzahl Stifte in den entsprechenden Leiterplattenbohrungen positioniert und dann in einem Arbeitsgang gemeinsam eingepreßt werden können.

Diese Aufgabe wird erfindungsgemäß bei einem Kontaktstift der eingangs genannten Art durch die im Anspruch 1 definierte Merkmale.

Die Erfindung ermöglicht es, eine Vielzahl von Kontaktstiften in einem Vorbereitungsarbeitsgang auf der Leiterplatte zu positionieren, wobei die Positionierabschnitte dafür sorgen, daß die Stifte koaxial stehen, was nämlich bei den bekannten Stiften wegen der wesentlich dünneren Endabschnitte nicht der Fall wäre. Mit einer Pressvorrichtung können dann alle vorpositionierten Stifte in einem Arbeitsgang eingepreßt werden. Die Stifte brauchen dabei im Press-Stempel nicht eingeklemmt zu werden, da sie in der Leiterplatte wackelfrei positioniert sind. Mit einer ebenen Pressfläche kann das Einpressen der Stifte in einem Arbeitsgang erfolgen. Ganze Steckverbinder, in denen die Stifte montiert sind, können in gleicher Weise eingepreßt werden.

Die Länge des Positionierabschnittes entspricht der Stärke der Leiterplatte, so daß die Kontaktstifte über die gesamte Länge der Leiterplattenbohrungen geführt sind. Der dem Positionierabschnitt vorgeschaltete Einführabschnitt verjüngt sich zum Stiftende hin und erleichert die Positionierung.

Die Kontaktstifte nach dem Stand der Technik weisen zwar ebenfalls den sich verjüngenden Übergangsabschnitt auf, der aber dem Einpressabschnitt unmittelbar vorgeschaltet ist. Würde man einen solchen Kontaktstift nach dem erfindungsgemäßen Verfahren in einem zweischrittigen Verfahrensablauf bestücken, so würde er in der ersten Verfahrensstufe mit seinem konischen Übergangsabschnitt auf dem Bohrungsrand der Leiterplatte aufsitzen und könnte bei Weitertransport der Platte unkontrolliert zur Seite kippen. Der erfindungsgemäß vorgesehene Positionierabschnitt verhindert dies.

Eine Weiterbildung der Erfindung besteht darin, daß die Außenkanten der Rippen des Positionsabschnittes gerundet sind und ihr Krümmungsradius größer als derjenige der Außenkantenrundungen des Einpressabschnittes ist. Die Radien beider Außenkantenrundungen sind kleiner als der Lochradius der Leiterplattenbohrung, so daß die Kontaktzonen genaugenommen linienartig ausgebildet sind.

Eine Weiterbildung der Erfindung ist dann noch darin zu sehen, daß die die Kontaktzonen im Querschnitt paarweise miteinander verbindenden Diagonalen im Einpressabschnitt und im Positionierabschnitt jeweils einen Schnittpunkt aufweisen und daß beide Schnittpunkte beabstandet sind. Der Schnittpunkt der Diagonalen des Positionierabschnittes fällt wenigstens angenähert mit dem Mittelpunkt des Umkreises der Kontaktzonen des Positionierabschnittes zusammen. Der Schnittpunkt der Diagonalen des Einpressabschnittes ist demgegenüber versetzt und liegt vorzugsweise in derselben, sich rechtwinklig zur Brücke des Positonierabschnittes erstreckenden Axialebene.

Ein wichtiges weiteres Merkmal der Erfindung ist darin zu sehen, daß die Kontaktzonen des Einpressabschnittes, des Übergangsabschnittes, des Positionierabschnittes und des Einführabschnittes stetig und absatzfrei ineinander übergehen. Um dies zu erreichen werden beidseitig der Brücken der Abschnitte Mulden gebildet, wobei der Muldenquerschnitt des Einpressabschnittes größer als derjenige des Positionierabschnittes ist. Die Brücke des Positionierabschnittes ist vorzugsweise kürzer als diejenige des Einpressabschnittes.

Die Erfindung betrifft weiterhin ein Verfahren nach dem Anspruch 9, zum Bestücken von Leiterplatten mit Kontaktstiften und dieses Verfahren besteht darin, daß die Kontaktstifte einzeln oder in Gruppen in die Leiterplattenbohrungen soweit eingeführt werden, daß ihre Positionierabschnitte in den Leiterplattenbohrungen aufgenommen und geführt sind und daß in mindestens einem weiteren Verfahrensschritt mindestens eine Gruppe von Kontaktstiften gemeinsam in die Leiterplattenbohrungen eingepreßt wird.

Anhand der Zeichnung, die ein Ausführungsbeispiel zeigt, wird die Erfindung näher beschrieben.

Es zeigt:

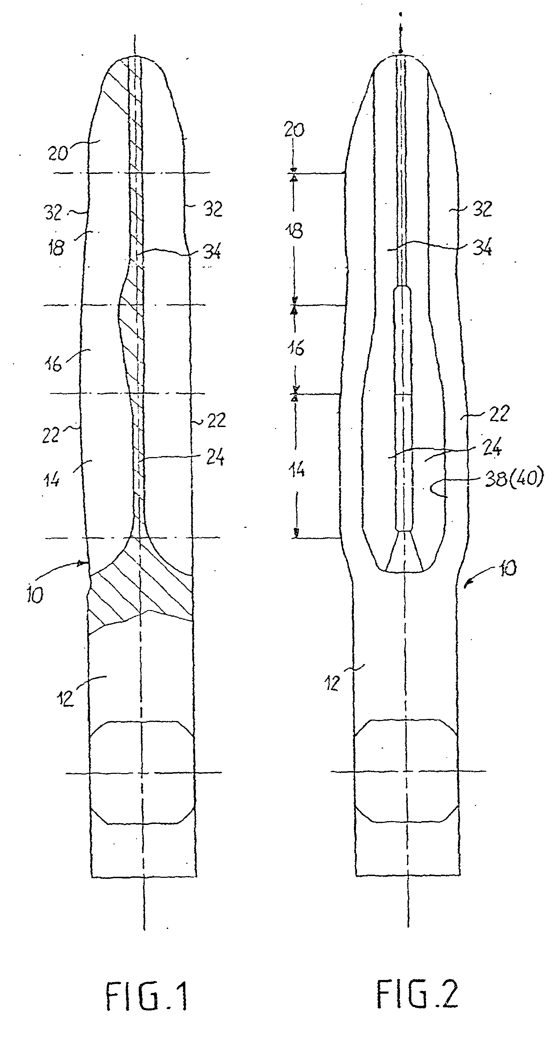

- FIG. 1: eine Seitenansicht des neuen Kontaktstiftes teilweise im Schnitt,
- FIG. 2: eine Draufsicht auf den Kontaktstift gemäß FIG. 1,
- FIG. 3: eine Ansicht mit zwei übereinander gelegten Radialschnitten, deren einer den Einpressabschnitt und deren anderer den Positionierabschnitt darstellt.

Ein Kontaktstift 10 hat einen Schaft 12 mit oktogonaler Kontur und besitzt einen Einpressabschnitt 14, einen sich leicht verjüngenden Übergangsabschnitt 16, einen sich daran anschließenden Positionierabschnitt 18 und einen Einführabschnitt 20, der sich zum Stiftende hin verjüngt. Im Bereich des Einpressabschnittes hat der Kontaktstift einen Querschnitt, der sich aus zwei Rippen 22 und einer diese verbindenden Brücke 24 zusammensetzt. Die Brücke ist dünnwandig und kreisbogenförmig ausgebildet und stellt ein federelastisches Mittel dar, aufgrund dessen die beiden Rippen 22 beim Einpressen des Kontaktstiftes in den Einpressabschnitt aufeinanderzu bewegt werden, um die vier an den Außenkanten der Rippen gebildeten Kontaktzonen 26 derart einwärts zu verlagern, daß sie vom Umkreis 28 auf den im Durchmesser kleineren Umkreis 30 gelangen, welcher dem Innendurchmesser der Leiterplattenbohrung entspricht.

Im Positionierbereich 18 hat der Kontaktstift 10 ebenfalls zwei Rippen 32, die durch eine Brücke 34 miteinander verbunden sind. Die Außenkanten der Rippen 32 sind ebenso wie diejenigen der Rippen 22 gerundet und bilden somit vier Kontaktzonen 36, die einen größeren Krümmungsradius als die Kontaktzonen 26 haben. Die Kontaktzonen 36 liegen auf einem Kreis, der abzüglich eines Schiebespiels dem Kreis 30 entspricht. Die Rippen 32 und die Brücke 34 sind spiegelsymmetrisch zu zwei ortogonalen Richtungen ausgebildet und die Diagonalen, die zwei einander diametral gegenüberliegende Kontaktzonen 36 miteinander verbinden, schneiden sich in einem Punkt, der mit dem Mittelpunkt der Kreise 28, 30 zusammenfällt. Die Rippen 32 und die Brücke 34 bilden einen unverformbaren Bereich, der in die Bohrung der Leiterplatte paßt.

Auch im Übergangsbereich 16 weist der Kontaktstift 10 zwei Rippen auf, die durch eine entsprechende Brücke miteinander verbunden sind, wobei an den gerundeten Außenkanten Kontaktzonen gebildet werden, die die Kontaktzonen 26 und 36 absatzfrei und unter stetigem Übergang miteinander verbinden. Auf diese Weise werden in den Abschnitten 14, 16, 18 beidseitig der Brücken Mulden 38, 40 gebildet, die von den einander zugewandten schrägen Flanken der Rippen 22, 32 und der Brücken 24, 34 begrenzt werden. Der Muldenquerschnitt ist im Bereich des Positionierabschnittes 18 am kleinsten und vergrößert sich bis auf den Einpressabschnitt 14. Im Ausführungsbeispiel erstrecken sich die Mulden 38, 40 auch längs des Einführungsabschnittes 20, um auch hier Rippenausbildungen mit einem stetigen Anschluß an den Positionierabschnitt 18 zu schaffen.

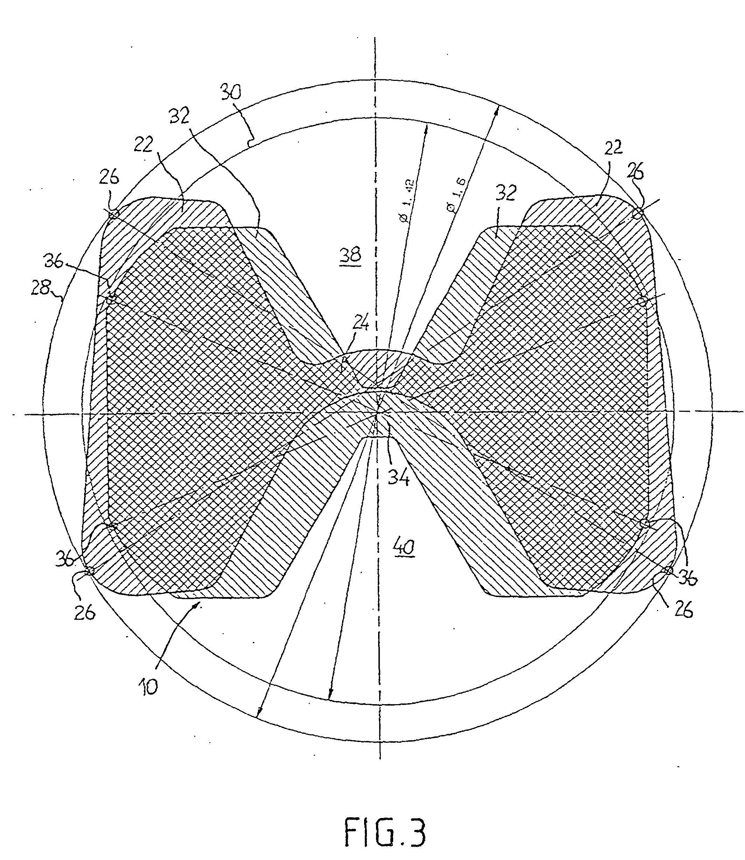

Wie sich aus FIG. 3 ergibt, liegt der Kreis 30 auf einem Druchmesser von 1,42 mm, während der Umkreis 28 für die Kontaktzonen 26 des Einpressabschnittes 14 auf einem Durchmesser von 1,6 mm liegt. Daraus resultiert eine radiale Einwärtsverformung der Kontaktzonen 26 beim Einpressen in den Einpressabschnitt 14 von 0,09 mm.

Ein wesentliches Merkmal der Erfindung besteht darin, daß der Positionierabschnitt 18 wenigstens angenähert dieselbe Länge wie der Einpressabschnitt 14 hat. Damit ist sichergestellt, daß der Kontaktstift mit seinem Positionierabschnitt 18 die Leiterplattenbohrung vollständig durchsetzt, so daß auch Rüttelbewegungen kein Kippen oder Wackeln der Kontaktstifte in den Leiterplattenbohrungen hervorrufen können.

## Patentansprüche

1. Kontaktstift zur lötfreien Befestigung in metallisierten Leiterplattenbohrungen mit einem Schaft, einem elastisch verformbaren Einpressabschnitt und einer Stiftkuppe, wobei der Einpressabschnitt mindestens drei, sich im wesentlichen achsparallel über die Länge des Einpressabschnittes (14) erstreckende Kontaktzonen (26) aufweist und mit einem, dem Einpressabschnitt (14) in Einsteckrichtung vorgeschalteten Übergangsabschnitt (16), der ebenfalls Kontaktzonen aufweist, die sich an diejenigen des Einpressabschnittes (14) anschließen und auf einer wenigstens angenähert konischen Übergangsfläche liegen und im Abstand von der Stiftkuppe enden, wobei dem Übergangsabschnitt (16) ein Positionierabschnitt (18) vorgeschaltet ist, der ebenfalls Kontaktzonen (36) aufweist, die wenigstens angenähert achsparallel verlaufen und die an die Kontaktzonen des Übergangsabschnittes (16) anschließen und in einem sich verjüngenden Einführabschnitt (20) enden, **dadurch gekennzeichnet, daß** der Einpressabschnitt (14) durch zwei Rippen (22) und eine diese miteinander verbindende gebogene oder gewellte dünne Brücke (24) gebildet ist und an den vier gerundeten Außenkanten der Rippen (22) die Kontaktzonen (26) aufweist, und daß der Positionierabschnitt (18) ebenfalls zwei Rippen (32) und eine Verbindungsbrücke (34) aufweist und daß sich die Querschnittsformen der Rippen (22, 32) und der Brücken (24, 34) beider Abschnitte (14, 18) voneinander unterscheiden, *wobei die Kontaktzonen des Einpressabschnitts auf einem Durchmesser (28) liegen, der größer als ein Durchmesser ist, auf dem angenähert die Kontaktzonen (36) des Positionierabschnitts (18) liegen.*

2. Kontaktstift nach Anspruch 1, **dadurch gekennzeichnet, daß** die Außenkanten der Rippen (32) des Positionierabschnittes (18) gerundet sind und ihr Krümmungsradius größer als derjenige der Außenkantenrundungen des Einpressabschnittes (14) ist.

3. Kontaktstift nach einem der Ansprüche 1 bis 2, **dadurch gekennzeichnet, daß** die die Kontaktzonen (26, 36) im Querschnitt paarweise miteinander verbindenden Diagonalen im Einpressabschnitt (14) und im Positionierabschnitt (18) jeweils einen Schnittpunkt aufweisen und beide Schnittpunkte beabstandet sind.

4. Kontaktstift nach Anspruch 3, **dadurch gekennzeichnet, daß** der Schnittpunkt der Diagonalen des Positionierabschnittes (18) wenigstens angenähert mit dem Mittelpunkt des Umkreises der Kontaktzonen (36) des Positionierabschnittes (18) zusammenfällt.

5. Kontaktstift nach Anspruch 3 oder 4, **dadurch gekennzeichnet, daß** die Schnittpunkte der Diagonalen der Kontaktzonen (26) des Einpressabschnittes (14) und derjenigen der Kontaktzonen (36) des Positionierabschnittes (18) wenigstens angenähert in einer sich rechtwinklig zur Brücke (34) des Positionierabschnittes (18) erstreckenden Axialebene liegen.

6. Kontaktstift nach einem der Ansprüche 4 bis 5, **dadurch gekennzeichnet, daß** die Brücke (34) des Positionierabschnittes (18) kürzer als diejenige des Einpressabschnittes (14) ist.

7. Kontaktstift nach einem der Ansprüche 1 bis 6, **dadurch gekennzeichnet, daß** beidseitig der Brücken (24, 34) beider Abschnitte (14, 18) Mulden (38, 40) gebildet werden und daß die Muldenquerschnitte des Einpressabschnittes (14) größer als diejenigen des Positionierabschnittes (18) sind.

8. Kontaktstift nach einem der Ansprüche 1 bis 7, **dadurch gekennzeichnet, daß** der Schaft (12) oktogonal konturiert und vier Breitseiten sowie vier, diese jeweils verbindende kürzere Diagonalseiten aufweist.

9. Verfahren zum Bestücken von Leitenplatten mit Kontaktstiften nach einem oder mehreren der Ansprüche 1 bis 8, **dadurch gekennzeichnet, daß** die Kontaktstifte (10) einzeln oder in Gruppen in die Leiterplattenbohrungen soweit eingeführt werden, daß ihre Positionierabschnitte (18) in den Leiterplattenbohrungen aufgenommen sind und daß in mindestens einem weiteren Verfahrensschritt mindestens eine Gruppe von Kontaktstiften (10) gemeinsam tiefer in die Leiterplattenbohrungen eingedrückt werden, bis deren Einpressabschnitte (14) mindestens zum größten Teil in den Leiterplattenbohrungen aufgenommen sind.

## Claims

1. A contact pin for solderless attachment in metallized printed circuit board holes having a shank, an elastically deformable impressing portion and a shank cap, wherein the impressing portion is furnished with at least three contact zones (26) extending essentially parallel to the axis and over the length of impressing portion (14), and a transition portion (16) connected in front of impressing portion (14) in the direction of insertion, which is also furnished with contact zones that are adjacent to those of impressing portion (14) and are located on an at least approximately conical transition surface and terminate at a distance from the shank cap, wherein a locating portion (18) is connected in front of transition portion (16) and is also furnished with contact zones (36) that extend at least approximately parallel to the axis and are adjacent to the contact zones of transition portion (16) and that terminate in a tapered insertion portion (20), **characterized in that** impressing portion (14) is formed by two shaped elements (22) and a thin, angled or corrugated bridge (24) connecting the shaped elements and is furnished with the contact zones (26) at the four rounded outer extremities of the shaped elements (22), and that locating portion (18) is also furnished with two shaped elements (32) and a connecting bridge (34) and that the cross-sectional shapes of shaped elements (22, 32) and bridges (24, 34) of the two portions (14, 18) differ from one another, *wherein the contact zones of impressing portion occupy a diameter (28) that is greater than a diameter in which contact zones (36) of locating portion (18) are positioned approximately.*

2. The contact pin according to claim 1, **characterized in that** the outer extremities of shaped elements (32) of locating portion (18) are rounded and the radius of curvature thereof is greater than that of the radii of curvature of the outer extremities of impressing portion (14).

3. The contact pin according to any of claims 1 to 2, **characterized in that** the cross members in impressing portion (14) and in locating portion (18) transversely connecting contact zones (26, 36) together in pairs each have an intersection point and both intersection points are at a distance with respect to one another.

4. The contact pin according to claim 3, **characterized in that** the intersection point of the cross members of locating portion (18) at least approximately coincides with the center of the circumference of contact zones. (36) of locating portion (18).

5. The contact pin according to claims 3 or 4,
**characterized in that** the intersection points of the cross members of contact zones (26) for impressing portion (14) and the intersection points of the cross members of contact zones (36) for locating portion (18) are located at least approximately in an axial plane perpendicular to the bridge (34) of locating portion (18).

6. The contact pin according to any of claims 1 to 5, **characterized in that** the bridge (34) of locating portion (18) is shorter than that of impressing portion (14).

7. The contact pin according to any of claims 1 to 6, **characterized in that** recesses (38, 40) are conformed on both sides of the bridges (24, 34) of both portions (14, 18), and that the profiles of the recesses of impressing portion (14) are larger than those of locating portion (18).

8. The contact pin according to any of claims 1 to 7, **characterized in that** shank (12) is octagonally shaped and has four longer sides and four shorter sides between and connecting the four longer sides.

9. A method for assembling printed circuit boards with contact pins according to one or more of claims 1 to 8, **characterized in that** the contact pins (10) are inserted singly or in groups into the holes in the printed circuit board until their locating portions (18) are fully located within the circuit board holes, and that in at least one further step of the method at least one group of contact pins (10) is jointly pressed deeper into the printed circuit board holes, until the impressing portions (14) thereof are at least mostly located within the printed circuit board holes.

## Revendications

1. Broche de contact destinée à être fixée sans soudure dans des perçages de carte de circuits imprimés, ayant une tige, un tronçon d'enfoncement élastiquement déformable et une calotte de broche, dans laquelle le tronçon d'enfoncement présente au moins trois zones de contact (26) s'étendant essentiellement parallèles à l'axe sur la longueur du tronçon d'enfoncement (14) et avec un tronçon de transition (16) en aval du tronçon d'enfoncement (14) dans la direction d'enfichage, lequel tronçon de transition présente également des zones de contact, qui sont contiguës à celles du tronçon d'enfoncement (14) et se trouvent sur une surface de transition au moins approximativement conique et se terminent à distance de la calotte de broche, un tronçon de positionnement (18) étant en amont du tronçon de transition (16) et présentant également des zones de contact (36) qui se prolongent au moins approximativement parallèles à l'axe et qui sont contiguës avec les zones de contact du tronçon de transition (16) et qui se terminent dans un tronçon d'introduction qui s'effile, **caractérisé en ce que** le tronçon d'enfoncement (14) est formé par deux nervures (22) et un pont mince (24) courbé ou ondulé reliant ces dernières entre elles et présente les zones de contact (26), au niveau des quatre bords externes arrondis des nervures (22) et **en ce que** le tronçon de positionnement (18) présente également deux nervures (32) et un point de liaison (34) et que les formes des sections des nervures (22, 32) et des ponts (24, 34) des deux tronçons (14, 18) diffèrent l'une de l'autre, *les zones de contact du tronçon d'enfoncement se trouvant sur un diamètre (28), qui est supérieur à un diamètre sur lequel se trouvent approximativement les zones de contact (36) du tronçon de positionnement (18).*

2. Broche de contact selon la revendication 1, **caractérisée en ce que** les bords externes des nervures (32) du tronçon de positionnement (18) sont arrondis et leur rayon de courbure est supérieur à celui des arrondis de bord externe du tronçon d'enfoncement (14).

3. Broche de contact selon l'une quelconque des revendications 1 à 2, **caractérisée en ce que** les diagonales reliant entre elles par paires les zones de contact (26, 36) dans la section transversale présentent à chaque fois un point d'intersection dans le tronçon d'enfoncement (14) et dans le tronçon de positionnement (18) et que les deux points d'intersection sont espacés l'un de l'autre.

4. Broche de contact selon la revendication 3, **caractérisée en ce que**, le point d'intersection des diagonales du tronçon de positionnement (18) coïncide au moins approximativement avec le centre du cercle circonscrit aux zones de contact (36) du tronçon de positionnement (18).

5. Broche de contact selon la revendication 3 ou 4, **caractérisée en ce que** les points d'intersection des diagonales des zones de contact (26) du tronçon d'enfoncement (14) et ceux des zones de contact (36) du tronçon de positionnement (18) se trouvent au moins approximativement dans un plan axial s'étendant de façon perpendiculaire au pont (34) du tronçon de positionnement (18).

6. Broche de contact selon l'une quelconque des revendications 4 à 5, **caractérisée en ce que** le pont (34) du tronçon de positionnement (18) est plus court que celui du tronçon d'enfoncement (14).

7. Broche de contact selon l'une quelconque des revendications 1 à 6, **caractérisée en ce que** des auges (38, 40) sont formées des deux côtés des ponts (24, 34) des deux sections (14, 18) et que les sections des auges du tronçon d'enfoncement (14) sont plus grandes que celles du tronçon de positionnement (18).

8. Broche de contact selon l'une quelconque des revendications 1 à 7, **caractérisée en ce que** la tige (12) présente un contour octogonal et quatre côtés larges ainsi que quatre côtés diagonaux plus courts reliant respectivement ceux-ci.

9. Procédé pour équiper des cartes de circuits imprimés, de broches de contact selon l'une ou plusieurs des revendications 1 à 8, **caractérisé en ce que** les broches de contact (10) sont introduites individuellement ou en groupes dans les perçages de cartes de circuits imprimés dans la mesure où leurs tronçons de positionnement (18) sont reçus dans les perçages de cartes de circuits imprimés et **en ce que**, dans au moins une étape de procédé supplémentaire, au moins un groupe de broches de contacts (10) sont enfoncées conjointement plus profondément dans les perçages de cartes de circuits imprimés, jusqu'à ce que leur tronçons d'enfoncement (14) soient reçus au moins en grande partie dans les perçages de cartes de circuits imprimés.
